# EUROPEAN PATENT SPECIFICATION

(11) **EP 1 170 808 B1**
(45) Date of publication and mention of the grant of the patent: **30.09.2009**
(21) Application number: 00202385.1
(22) Date of filing: 07.07.2000
(51) Int. Cl.: H01L 41/08

(54) **Piezoelectric device for actuating an operating element associated thereto**
Piezoelektrische Anordnung zur Antreiben eines damit verbundenen Elements
Dispositif piézoelectrique pour actionner un élément associé

(43) Date of publication of application: 09.01.2002
(73) Proprietor: ABB Research Ltd., 8050 Zürich (CH)
(72) Inventor: Bertolotto, Blanc Giuseppe, 10020 Lauriano (TO) (IT); Mandurino, Pietro, 40141 Bologna (IT)
(74) Representative: Giavarini, Francesco

(56) References cited:
- US-A- 4 363 991
- US-A- 4 849 668

## Description

The present invention relates to a piezoelectric device for actuating an operating element operatively associated thereto.

It is well-known in the art the use of controlling devices which are devised to control the functioning of technical systems to which they are coupled, such as electrical or hydraulic networks, plants, operating machines, apparatuses or components et cetera, and to prevent, or at least to minimize, technical problems which may occur during their service and can affect their performances, lead to malfunctioning or even to breakdown.

These controlling devices are basically composed of three parts: a first part comprising a sensor that checks one or more parameters, which are indicative of the proper functioning of the system, and outputs signals representing the values of the parameters checked; a second part comprising a control circuit which processes the signals received from the sensor, compares them with predetermined threshold values and, if necessary, outputs an operating command; a third part comprising actuating means which, on the basis of the operating command sent by the control circuit, intervene operatively on the system. For example, these interventions may result in the disconnection of some parts of an electric network, switching on/off of apparatuses or components, opening/closing of ducts, actuation of kinematic chains et cetera.

At the present state of the art, known devices, although they are quite satisfying in applications, still present some drawbacks and disadvantages.

In particular, one of the most critical aspects of known devices resides in the fact that the control circuit introduces significant time delays in the transmission of signals from the sensor to the actuating means. These time delays have a negative impact on the promptness of operations, cause late interventions, and definitely reduce the quality and effectiveness of the devices themselves. Furthermore, the control circuit, which generally comprises several electronic and/or electric components, may be constructively sophisticated, is per se expensive, and needs a dedicated source of power, thus increasing the design and production costs.

In addition, also actuating means usually have a large and complex structure in comparison with the sensors, they can require the use of cumbersome and heavy components depending on the applications, and are economically expensive; moreover, in many cases, both sensors and actuating means need a specific source of power supplying.

Finally, another disadvantage of known devices which should not be overlooked consists of the fact that, in case of long distance transmissions between the sensor and the actuating means, and since the power required for their functioning is significant, the signals transmitted can be strongly attenuated or even lost; alternatively, in order to reduce the attenuation of the signals, it is necessary to increase the energy supplied to the device.

The main aim of the present invention is to provide a device for actuating an operating element operatively associated thereto, which allows to overcome the drawbacks and disadvantages of the prior art, and in particular, to drastically reduce the time delay in the transmission of signals from the sensor to the actuating means.

US 4 363 991 discloses a configuration of a piezoelectric sensor and actuator provided on a common structural member and in electrical connection with each other.

The sensor provides feedback to the actuator about forces acting on the structural member which are minimised by deforming the structural member with the piezoelectric actuator.

Within the scope of this aim, an object of the present invention is to provide a device for actuating an operating element operatively associated thereto, whose operative interventions are faster and prompter in comparison with those of prior art devices.

Another object of the present invention is to provide a device for actuating an operating element operatively associated thereto, which allows to prevent, or at least to minimize, the attenuation of the signals transmitted, even in case of long distance transmissions.

A further object of the present invention is to provide a device for actuating an operating element operatively associated thereto, which allows to reduce the amount of energy required for its functioning and therefore to eliminate or at least to reduce, the use of additional and dedicated source of power supplying.

Yet a further object of the present invention is to provide a device for actuating an operating element operatively associated thereto, which has a simplified structure in comparison with prior art devices, which allows to avoid the use of cumbersome and heavy components and to reduce design and production costs.

Another object of the present invention is to provide a device for actuating an operating element operatively associated thereto, which is highly reliable, relatively easy to manufacture and at competitive costs.

This aim, these objects and others which will become apparent hereinafter are achieved by a piezoelectric device for actuating an operating element operatively associated thereto, characterized in that it comprises:
- a first structural element which moves under the action of a stress or forces applied thereon, and first piezoelectric means which are operatively coupled to said first structural element so as to deform and produce an electrical signal in response to its movement;
- second piezoelectric means operatively coupled to a second structural element; and
- conducting means for electrically coupling said first piezoelectric means to said second piezoelectric means; the second piezoelectric means receiving said electric signal and deforming so as to determine a movement of the second structural element and the consequent actuation of said operating element.

The device according to the invention allows to completely avoid the use of a control circuit; as a result, the time delay in the transmission of signals from the sensor, which is constituted by the coupling first structural element-first piezoelectric means, to the actuating means, which are represented by the coupling second structural element-second piezoelectric means, is drastically reduced.

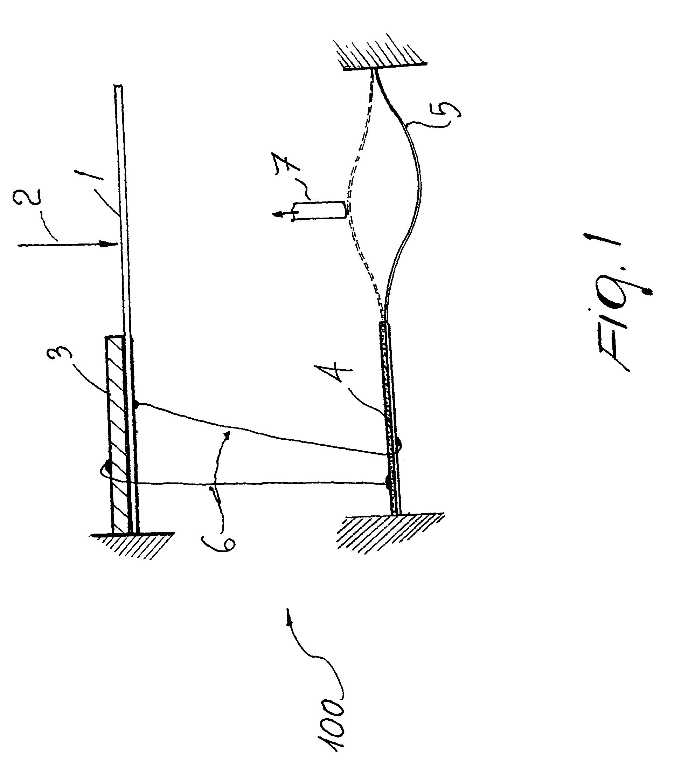

Further characteristics and advantages of the present invention will become apparent from the following description of preferred but not exclusive embodiments illustrated only by way of non-limitative example with the accompanying drawing of Figure 1 which schematically shows a side view of a possible embodiment of the device according to the invention.

With reference to figure 1, the piezoelectric device according to the invention, indicated by the reference numeral 100, comprises a first structural element 1 which moves under the action of a stress or forces 2 applied thereon; as illustrated in figure 1, the first structural element 1 can be constituted by a thin metallic lamina, while the stress or forces 2 may be due to various causes. For example, the stress 2 could be a mechanical stress, caused for example by a fluid which exerts a pressure on the lamina 1, or a thermal stress which causes its thermal deformation; forces may be due to a mechanical action exerted on the element 1 by an operator, et cetera.

First piezoelectric means 3 are operatively coupled to the first structural element 1 so as to deform and produce an electrical signal in response to its deformation; in particular, in order to maximize the amount of energy which can be extracted from the deformation of the element 1 and transformed into electrical energy, the first piezoelectric means comprise a piezoelectric material at high energy gain. Preferably said first piezoelectric means 3 comprise at least one layer of a ceramic piezoelectric material in a bimorph configuration, such as a barium or a lead zirconate titanate (PZT) piezoelectric compound, which is fixed on at least a part of one surface of the lamina 1.

The piezoelectric device 100 comprises second piezoelectric means 4 which are operatively coupled to a second structural element 5; preferably, the second structural element 5 is constituted by a bistable metallic lamina; according to the applications and/or specific needs, also the first structural element 1 can be formed by a bistable metallic lamina.

According to a preferred embodiment, also the second piezoelectric means 4 comprise at least one layer of a ceramic piezoelectric material in a bimorph configuration, such as a barium or a lead zirconate titanate (PZT) piezoelectric compound, which is fixed on at least a part of one surface of the lamina 5.

Fixing of the layers 3 and 4 to the corresponding surfaces of laminas 1 and 5 can be realized by any suitable technique, for example by gluing with adhesive materials, such as epoxy resins.

Alternatively, and depending on the applications, the first and second piezoelectric means 3 and 4 may comprise one or more layers of an inorganic crystal piezoelectric material, such as quartz and barium titanate, or of an organic polymer piezoelectric material, such as polyvinylidene fluoride (PVDF), polyvinyl fluoride or polyvinyl chloride, which exhibit piezoelectric properties when properly treated. For example, organic polymer piezoelectric materials, thanks to the fact that they can be easily formed into thin films, could be advantageously used when the device must have a structural flexibility.

Furthermore, according to various and extremely flexible solutions, the layers of piezoelectric material can be fixed to the corresponding structural element in many different configurations; for example, it is possible to use only one layer of material which is associated to a portion of the structural element, or a plurality of pieces which are placed side by side or are arranged in a patch configuration, or a plurality of layers which are positioned in a stack configuration. These configurations can be also realized on different surfaces of the structural elements; for example, in case of the laminas 1 and 5, it is possible to provide two layers of piezoelectric material each of which is fixed to a corresponding face of the metallic lamina with the lamina interposed therebetween. In addition, some layers of different piezoelectric materials can be simultaneously or interchangeably used.

The device 100 is provided with conducting means 6 which electrically couple the first piezoelectric means 3 to the second piezoelectric means 4; according to a preferred embodiment and with a solution which is functionally effective, structurally simple and economically inexpensive, the conducting means 6 are consituted by a couple of conducting wires 6 whose ends are fixed to the first piezoelectric means 3 and to the second piezoelectric means 4, respectively.

In this way, in the presence of a stress or forces 2 which act on the first lamina 1 and cause its movement, the first piezoelectric means 3 deform and produce an electrical signal; this electrical signal is supplied, by means of the conducting wires 6, to the second piezoelectric means 4 which, in turn, deform so as to determine a movement of the second lamina 5 and the consequent actuation of an operating element 7 operatively coupled thereto. This operating element 7 can be for example, an element of a kinematic chain, an electric contact, a laser beam whose path, following the movement of the lamina 5, is changed so as to determine a subsequent operation, an element which diverts the flow of a fluid, et cetera.

In particular, if the second lamina 5 is a bistable lamina, it moves from a first stable equilibrium position, represented with a continuos line in figure 1, to a second stable equilibrium position, indicated in figure 1 with a dashed line; also the first structural element can move in the same way, if it is constituted by a bistable lamina. In this way, the energy delivered by the lamina 5 is higher than the activation energy provided by the wires 6; moreover, actuating operations are precisely repeatable and the reset of the device is accurate.

In practice it has been observed that the device according to the invention fully achieves the intended aim and objects, and gives many significant advantages in comparison with prior art devices; in fact, in the device according to the invention, the use of a control circuit is prevented and the time delay for transmitting signals from the sensing part to the actuating one is drastically reduced. As a consequence, the device 100 is characterized by very short response times which are much shorter than those of prior art devices unless they use a suitable electronic control circuit. It has in fact been found that the response time can be less than 3 millisecond; response time is defined as the time elapsing between when the stress or force 2 is applied on the first structural element 1 and when the second element 5 actuates the operating element 7.

In addition, the conducting wires 6 constitute a substantially passive electric circuit, i.e. a circuit which does not include any active component that requires a dedicated power supplying; moreover, also the sensor and actuator components, which are formed by the coupling first structural element-first piezoelectric means and second structural element-second piezoelectric means, respectively, do not require any dedicated power supply source. In this way, the energy required for the functioning of the whole device is low and the attenuation of the signals transmitted is significantly reduced, even in case of long distance transmissions; furthermore, sensor and actuating means are based on the same kind of components, with a reduced number of elements and according to a constructive solution which is simple and effective, thus allowing to reduce the production costs and to ease the design steps.

Another advantage that should not be overlooked resides in the fact that the device according to the invention, thanks to its structure, is suitable for being used in a wide range of applications, such as current interruption devices, valves, remote control devices, automation systems, et cetera. In case of current interruption devices or valves for example, the laminas 1 and 5 could be simply fixed at their ends, to the case of the current interruption device or to a wall of the valve.

In addition, by suitably designing the first and second structural elements, and the configuration of the piezoelectric means associated therewith, it is possible to precisely tune the reference threshold at which the device must intervene.

## Claims

1. A piezoelectric device (100) for actuating an operating element (7) operatively associated thereto, comprising :
- a first structural element (1) which moves under the action of a stress or forces (2) applied thereon, and first piezoelectric means (3) which are operatively coupled to said first structural element so as to deform and produce an electrical signal in response to its movement;
- second piezoelectric means (4) operatively coupled to a second structural element (5); and
- conducting means (6) for electrically coupling said first piezoelectric means to said second piezoelectric means; the second piezoelectric means receiving said electric signal and deforming so as to determine a movement of the second structural element and the consequent actuation of said operating element.

2. Piezoelectric device according to claim 1 **characterized in that** said second structural element is a bistable element movable from a first stable equilibrium position to a second stable equilibrium position.

3. Piezoelectric device according to one or more of the preceding claims **characterized in that** said conducting means comprise a substantially passive electric circuit.

4. Piezoelectric device according to claim 3 **characterized in that** said passive electric circuit comprises two electrical wires whose ends are fixed to the first piezoelectric means and to the second piezoelectric means.

5. Piezoelectric device according to one or more of the preceding claims **characterized in that** said first piezoelectric means comprise at least one layer of piezoelectric material fixed to the first structural element.

6. Piezoelectric device according to one or more of the preceding claims **characterized in that** said second piezoelectric means comprise at least one layer of piezoelectric material fixed to the second structural element.

7. Piezoelectric device according to claims 5 and 6 **characterized in that** said at least one layer of piezoelectric material comprises a ceramic piezoelectric material, or an inorganic crystal piezoelectric material, or an organic polymer piezoelectric material.

8. Piezoelectric device according to claim 6 **characterized in that** said first piezoelectric means comprises a piezoelectric material at high energy gain.

9. Piezoelectric device according to one or more of the preceding claims **characterized in that** the response time, defined as the time elapsing between when the stress is applied on the first structural element and when the second element actuates the operating element is less than 3 ms.

10. Piezoelectric device according to one or more of the preceding claims **characterized in that** said first structural element is a bistable element movable from a first stable equilibrium position to a second stable equilibrium position.

11. Current interruption device **characterized in that** it comprises a piezoelectric device according to one or more of the preceding claims.

12. A valve for opening/closing a pipe operatively coupled therewith, **characterized in that** it comprises a piezoelectric device according to one or more of the claims from 1 to 10.

## Patentansprüche

1. Piezoelektrische Vorrichtung (100) zum Betätigen eines damit betrieblich zugeordneten Betriebselements (7), aufweisend:
- ein erstes Strukturelement (1), das sich unter dem Einfluss von einer darauf ausgeübten Belastung oder Kraft (2) bewegt, und erste piezoelektrische Einrichtungen (3), die mit dem ersten Strukturelement betrieblich derart gekoppelt sind, dass sie in Reaktion auf die Bewegung des ersten Strukturelements verformt werden und ein elektrisches Signal erzeugen;
- zweite piezoelektrische Einrichtungen (4), die mit einem zweiten Strukturelement (5) betrieblich gekoppelt sind; und
- Leitungseinrichtungen (6) zum elektrischen Koppeln der ersten piezoelektrischen Einrichtungen mit den zweiten piezoelektrischen Einrichtungen; wobei die zweiten piezoelektrischen Einrichtungen das elektrische Signal empfangen und sich derart verformen, dass eine Bewegung des zweiten Strukturelements und die anschließende Betätigung des Betriebselements bestimmt werden.

2. Piezoelektrische Vorrichtung nach Anspruch 1, **dadurch gekennzeichnet, dass** das zweite Strukturelement ein bistabiles Element ist, das von einer ersten stabilen Gleichgewichtslage in eine zweite stabile Gleichgewichtslage bewegbar ist.

3. Piezoelektrische Vorrichtung nach einem oder mehreren der vorhergehenden Ansprüche, die **dadurch gekennzeichnet sind, dass** die Leitungseinrichtungen einen im Wesentlichen passiven elektrischen Schaltkreis aufweisen.

4. Piezoelektrische Vorrichtung nach Anspruch 3, **dadurch gekennzeichnet, dass** der passive elektrische Schaltkreis zwei elektrische Drähte aufweist, deren Enden an den ersten piezoelektrischen Einrichtungen und an den zweiten piezoelektrischen Einrichtungen befestigt sind.

5. Piezoelektrische Vorrichtung nach einem oder mehreren der vorhergehenden Ansprüche, **dadurch gekennzeichnet, dass** die ersten piezoelektrischen Einrichtungen zumindest eine Schicht aus einem piezoelektrischen Material aufweisen, die an dem ersten Strukturelement befestigt ist.

6. Piezoelektrische Vorrichtung nach einem oder mehreren der vorhergehenden Ansprüche, **dadurch gekennzeichnet, dass** die zweiten piezoelektrischen Einrichtungen zumindest eine Schicht aus einem piezoelektrischen Material aufweisen, die an dem zweiten Strukturelement befestigt ist.

7. Piezoelektrische Vorrichtung nach Anspruch 5 oder 6, **dadurch gekennzeichnet, dass** die zumindest eine Schicht aus einem piezoelektrischen Material ein keramisches piezoelektrisches Material oder ein anorganisches kristallines piezoelektrisches Material oder ein organisches polymeres piezoelektrisches Material aufweist.

8. Piezoelektrische Vorrichtung nach Anspruch 6, **dadurch gekennzeichnet, dass** die ersten piezoelektrischen Einrichtungen ein piezoelektrisches Material mit einem hohen Energiegewinn aufweisen.

9. Piezoelektrische Vorrichtung nach einem oder mehreren der vorhergehenden Ansprüche, **dadurch gekennzeichnet, dass** die Reaktionszeit, die als die Zeit definiert ist, die zwischen dem Anlegen der Belastung an das erste Strukturelement und dem Betätigen des Betriebselements durch das zweite Strukturelement verstreicht, weniger als 3 ms beträgt.

10. Piezoelektrische Vorrichtung nach einem oder mehreren der vorhergehenden Ansprüche, **dadurch gekennzeichnet, dass** das erste Strukturelement ein bistabiles Element ist, das von einer ersten stabilen Gleichgewichtslage in eine zweite stabile Gleichgewichtslage bewegbar ist.

11. Stromunterbrechungsvorrichtung, **dadurch gekennzeichnet, dass** sie eine piezoelektrische Vorrichtung nach einem oder mehreren der vorhergehenden Ansprüche aufweist.

12. Ventil zum Öffnen / Schließen einer Leitung, die mit demselben betrieblich gekoppelt ist, **dadurch gekennzeichnet, dass** es eine piezoelektrische Vorrichtung nach einem oder mehreren der Ansprüche 1 bis 10 aufweist.

## Revendications

1. Dispositif piézoélectrique (100), pour actionner un élément d'actionnement (7) lui étant associé fonctionnellement, comprenant :
- un premier élément structurel (1), se déplaçant sous l'action d'une contrainte ou de forces (2) appliquées sur lui, et des premiers moyens piézoélectriques (3), couplés fonctionnellement audit premier élément structurel, de manière à se déformer et à produire un signal électrique, en réponse à son déplacement ;
- des deuxièmes moyens piézoélectriques (4), couplés fonctionnellement à un deuxième élément structurel (5) ; et
- des moyens conducteurs (6), pour coupler électriquement lesdits premiers moyens piézoélectriques auxdits deuxièmes moyens piézoélectriques ; les deuxièmes moyens piézoélectriques recevant ledit signal électrique et se déformant, de manière à déterminer un déplacement du deuxième élément structurel et l'actionnement consécutif dudit élément d'actionnement.

2. Dispositif piézoélectrique selon la revendication 1, **caractérisé en ce que** ledit deuxième élément structurel est un élément bistable, déplaçable d'une première position d'équilibre stable à une deuxième position d'équilibre stable.

3. Dispositif piézoélectrique selon l'une ou plusieurs des revendications précédentes, **caractérisé en ce que** lesdits moyens conducteurs comprennent un circuit électrique sensiblement passif.

4. Dispositif piézoélectrique selon la revendication 3, **caractérisé en ce que** ledit circuit électrique passif comprend deux fils électriques, dont les extrémités sont fixées aux premiers moyens piézoélectriques et aux deuxièmes moyens piézoélectriques.

5. Dispositif piézoélectrique selon l'une ou plusieurs des revendications précédentes, **caractérisé en ce que** lesdits premiers moyens piézoélectriques comprennent au moins une couche de matériau piézoélectrique, fixée sur le premier élément structurel.

6. Dispositif piézoélectrique selon l'une ou plusieurs des revendications précédentes, **caractérisé en ce que** lesdits deuxièmes moyens piézoélectriques comprennent au moins une couche de matériau piézoélectrique, fixée sur le deuxième élément structurel.

7. Dispositif piézoélectrique selon les revendication 5 et 6, **caractérisé en ce que** ladite au moins une couche de matériau piézoélectrique comprend un matériau piézoélectrique céramique, ou un matériau piézoélectrique cristallin non organique, ou un matériau piézoélectrique polymère organique.

8. Dispositif piézoélectrique selon la revendication 6, **caractérisé en ce que** lesdits premiers moyens piézoélectriques comprennent un matériau piézoélectrique présentant un gain énergétique élevé.

9. Dispositif piézoélectrique selon l'une ou plusieurs des revendications précédentes, **caractérisé en ce que** le temps de réponse, défini comme étant le temps s'écoulant entre le moment auquel la contrainte est appliquée sur le premier élément structurel et le moment auquel le deuxième élément actionne l'élément d'actionnement, est inférieur à 3 ms.

10. Dispositif piézoélectrique selon l'une ou plusieurs des revendications précédentes, **caractérisé en ce que** ledit premier élément structurel est un élément bistable, déplaçable d'une première position d'équilibre stable à une deuxième position d'équilibre stable.

11. Interrupteur de courant électrique, **caractérisé en ce qu'**il comprend un dispositif piézoélectrique selon l'une ou plusieurs des revendications précédentes.

12. Valve, pour ouvrir/fermer un tube lui étant couplé fonctionnellement, **caractérisée en ce qu'**elle comprend un dispositif piézoélectrique selon l'une ou plusieurs des revendications 1 à 10.
